# EUROPÄISCHE PATENTSCHRIFT

(11) **EP 3 154 200 B1**
(45) Veröffentlichungstag und Bekanntmachung des Hinweises auf die Patenterteilung: **23.12.2020**
(21) Anmeldenummer: 15188750.2
(22) Anmeldetag: 07.10.2015
(51) Int. Cl.: H03K 17/96

(54) **KAPAZITIVE SCHALTVORRICHTUNG**
CAPACITATIVE SWITCH CIRCUIT
DISPOSITIF DE COMMUTATION CAPACITIF

(43) Veröffentlichungstag der Anmeldung: 12.04.2017
(73) Patentinhaber: RAFI GmbH & Co. KG, 88276 Berg (DE)
(72) Erfinder: Bulach, Dipl.-Ing. Eric, 88074 Meckenbeuren (DE); Klein, Petra, 88255 Baienfurt (DE); Hanser, Carmen, 88289 Waldburg (DE)
(74) Vertreter: Engelhardt, Volker

(56) Entgegenhaltungen:
- EP-A2- 1 688 308
- EP-A2- 2 385 630
- EP-A2- 2 611 034
- WO-A1-2009/036552
- US-A1- 2010 219 935
- US-B2- 6 958 459

## Beschreibung

Die Erfindung bezieht sich auf eine Kapazitive Schaltvorrichtung nach dem Oberbegriff des Patentanspruches 1.

Eine derartige Schaltvorrichtung kann beispielsweise aus der EP 2 645 571 A1 entnommen werden. Die im Inneren des Gehäuses angeordneten Sensorflächen sind bestromt und bestehen aus einem elektrisch leitfähigen Werkstoff, so dass durch diese Sensorfläche eine erste kapazitiv aufgeladene Platte gebildet ist. Das von den Sensorflächen abgestrahlte Kapazitätsfeld weist dabei in Richtung der Abdeckplatte und tritt durch diese hindurch. Sobald beispielsweise ein menschlicher Finger oder ein Bedienstift in Richtung der Abdeckplatte von außen zugeführt bzw. bewegt ist, verändert sich das Kapazitätsfeld der jeweiligen Sensorfläche. Eine solche Veränderung der Kapazität der Sensorfläche kann gemessen und ausgewertet sein, um beispielsweise ein elektrisches Schaltsignal für ein elektrisches Gerät zu generieren. Die Sensorfläche ist dabei einem Symbol- oder Schaltfeld zugeordnet, das zwischen der Sensorfläche und der Abdeckplatte verläuft.

Darüber hinaus sind im Inneren des Gehäuses mehrere Beleuchtungsmittel, beispielsweise LEDs vorgesehen, die fluchtend zu dem jeweiligen Schaltfeld angeordnet sind, so dass diese durch das Beleuchtungsmittel ausgeleuchtet werden können. Die Farbe der Beleuchtungsmittel kann sich je nach Schaltzustand verändern, so dass visuell erkennbar ist, ob eine Schaltfunktion erfolgte oder nicht.

Nachteiliger Weise sind die elektrischen Baueinheiten, beispielsweise die Sensorfläche, die Leiterplatte und dergleichen oftmals von außen erkennbar, wenn nämlich der Lichteinfall entsprechend gerichtet ist. Durch entsprechende Absorptionsmaßnahmen können diese Effekte zwar vermieden werden, jedoch entsteht von außen der optische Eindruck, dass eine ästhetisch nicht ansprechende Umgebung für die jeweiligen Schaltflächen, die dann in schwarz gehalten ist, entsteht.

Aus den US 6,95 8,45 9 B2, WO 2009/036552 A1 oder US 2010/0219935 A1 kann eine Schaltvorrichtung entnommen werden, die eine Abdeckplatte aufweist, um die elektrischen Bauteile im Inneren eines Gehäuses elektrisch zu isolieren und diese zudem vor Wassereintritt zu schützen. Um störende Lichtreflexionen zu verhindern, die insbesondere durch von außen einwirkende Lichtstrahlen entstehen, ist auf der Innenseite der Abdeckplatte ein Film oder ein Substrat aufgebracht, durch das die Lichtstrahlen reflektiert sind, ohne dass die kapazitive Eigenschaften der Schaltflächen verloren geht.

Es ist daher Aufgabe der Erfindung, eine kapazitive Schaltvorrichtung der eingangs genannten Gattung derart weiterzubilden, dass zum einen die Schaltfunktion, also die Zuordnung zwischen den Schaltflächen und deren Bedienbarkeit von außen ohne weiteres möglich ist und dass zum anderen während der Bedienung ein optischer Effekt entsteht, der dem Benutzer suggeriert, dass die Schaltsymbole auf einer Metallschicht angeordnet sind.

Diese Aufgabe ist erfindungsgemäß durch die Merkmale des kennzeichnenden Teils von Patentanspruch 1 gelöst.

Weitere vorteilhafte Weiterbildungen der Erfindung ergeben sich aus den Unteransprüchen.

Dadurch, dass im Strahlengang der Lichtwellen der Beleuchtungsmittel ein dünnwandiger Reflexionsschirm angeordnet ist, dass die von den Beleuchtungsmitteln in Richtung des Reflexionsschirmes abgestrahlten Lichtwellen durch diesen nach außen hindurchtreten und dass die von außen auf den Reflexionsschirm einfallenden Lichtwellen von diesem teilweise reflektiert, gebrochen und/oder gestreut sind, ist erreicht, dass der Reflexionsschirm nach außen einen optischen, metallischen Untergrundeffekt erzeugt. Gleichzeitig behindert die metallische Werkstoffauswahl des Reflexionsschirms den kapazitiven Schaltvorgang, der zwischen der im Inneren des Gehäuses vorgesehenen Sensorfläche und der Außenseite der Abdeckplatte stattfindet, nicht, denn der Flächenwiderstand des Reflexionsschirmes ist äußert hoch, wodurch das von der Sensorfläche abgestrahlte Kapazitätsfeld lediglich unwesentlich beeinflusst ist.

Es ist besonders vorteilhaft, wenn auf der Ober- und/oder Unterseite des Reflexionsschirmes eine lichtundurchlässige Absorptionsschicht aufgetragen ist, die beispielsweise einem Schaltsymbol in Form von Buchstaben, Zahlen oder dergleichen nachgebildet ist, so dass diese Fläche von den Lichtwellen der Beleuchtungsmittel nicht ausgeleuchtet ist. Folglich sind die im Inneren des Gehäuses angeordneten elektrischen Bauelemente, beispielsweise die Sensorfläche, die Leiterplatte und die auf der Leiterplatte angeordneten Transistoren, Widerstände und dergleichen von außen nicht sichtbar. Der Reflexionsschirm bildet daher bei entsprechender Hinterleuchtung eine Art Display zur Darstellung von entsprechenden Schaltsymbolen, zu denen die jeweils im Inneren des Gehäuses angeordnete Sensorfläche fluchtend angeordnet ist.

Weiterhin ist es besonders vorteilhaft ein oder mehrere lichtundurchlässige Abstandshalter zwischen den Beleuchtungsmitteln von zwei zueinander benachbart angeordneten Schaltflächen anzuordnen. Dadurch kann die jeweilige Schaltfläche unabhängig zu den benachbarten Schaltflächen beleuchtet bzw. hinterleuchtet werden.

Ebenso ist es möglich, hinter dem Reflexionsschirm ein Display, z.B. ein TFT-Display oder eine Flüssigkristallanzeige LCD, anzuordnen, das nur in aktivem Betrieb wahrnehmbar ist. Ausgeschaltet wird es durch die metallen anmutende Schicht des Reflexionsschirms verborgen.

In der Zeichnung ist ein erfindungsgemäßes Ausführungsbeispiel einer kapazitiven Schaltvorrichtung dargestellt, die nachfolgend näher erläutert ist. Im Einzelnen zeigt:

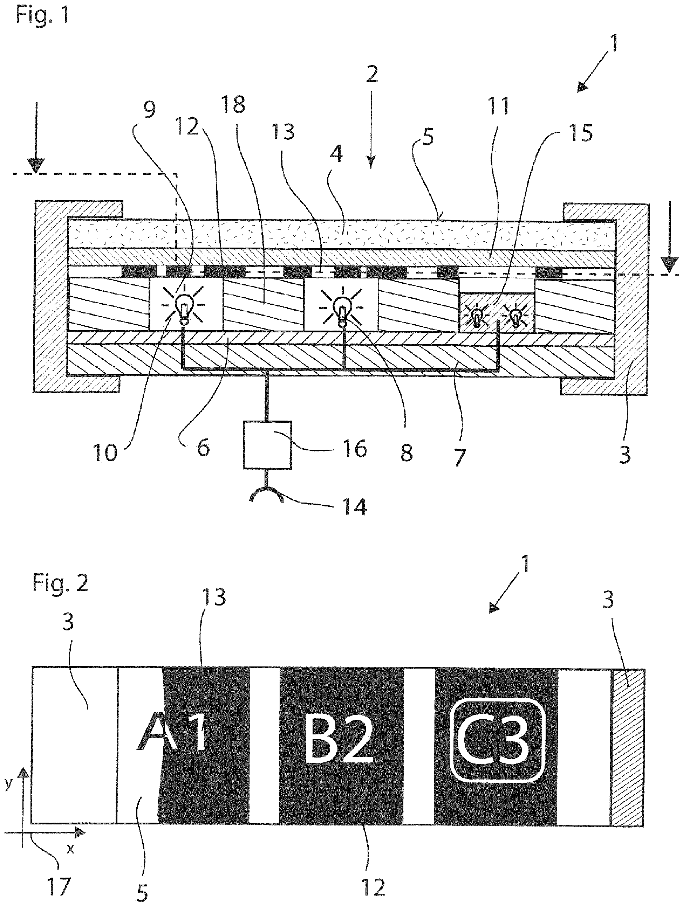

- Figur 1: eine kapazitive Schaltvorrichtung mit einem Gehäuse, in dem eine Abdeckplatte aus Glas angeordnet ist und mit einer im Inneren des Gehäuses vorgesehenen Leiterplatte, auf der Sensorflächen zur Erzeugung eines Kapazitätsfeldes, das die in Richtung der Abdeckplatte ausgestrahlt ist, angeordnet sind sowie mit einem zwischen der Abdeckplatte und der Sensorfläche vorgesehenen Reflexionsschirm, im Schnitt und
- Figur 2: die kapazitive Schaltvorrichtung gemäß Figur 1, in Draufsicht mit den auf dem Reflexionsschirm vorhandenen Schaltsymbolen, die durch eine Vielzahl von lichtundurchlässigen Absorptionsschichten gebildet sind.

Aus Figur 1 und 2 ist eine kapazitive Schaltvorrichtung 1 abgebildet, die aus einem Gehäuse 3 und einer fest an dieser angebrachten Abdeckplatte 4 besteht. Die Abdeckplatte 4 dient als Begrenzung für die im Inneren des Gehäuses 3 angeordneten elektrischen Bauteile, nämlich die auf einer Leiterplatte 7 angebrachten Sensorflächen 6, die aus einem elektrisch leitfähigen Werkstoff gebildet sind. Ein Benutzer erkennt die in der Abdeckplatte 4 integrierten Schaltflächen 5, die fluchtend zu den Sensorflächen 6 angeordnet sind, wenn der Benutzer im Wesentlichen senkrecht auf die Abdeckplatte 4 blickt. Die Bedien- und Blickrichtung ist schematisch mit einem Pfeil wiedergegeben und mit der Bezugsziffer 2 gekennzeichnet.

Die jeweiligen Sensorflächen 6 sind über die Leiterplatte 7 elektrisch mit einer Spannungsquelle 14 gekoppelt und werden von dieser bestromt, so dass die jeweilige Sensorfläche 6 ein Kapazitätsfeld, das die im Wesentlichen in Richtung der Abdeckplatte 4 gerichtet ist, ausstrahlt.

Darüber hinaus sind der jeweiligen Schaltfläche 5 ein oder mehrere Beleuchtungsmittel 8 zugeordnet, die mit der Stromquelle 14 elektrisch verbunden sind und von dieser im Bedarfsfalle bestromt werden. Die Beleuchtungsmittel 8 sind als sogenannte LEDs ausgestaltet und können unterschiedliche Farbtöne wiedergeben. Die von den Beleuchtungsmitteln 8 abgestrahlten Lichtwellen sind in Richtung der Abdeckplatte 4 gerichtet und durchlaufen die jeweilige Schaltfläche 5, um diese auszuleuchten.

Zwischen den Beleuchtungsmitteln 8 von zwei zueinander benachbart angeordneter Schaltflächen 5 können lichtdichte Abstandshalter 18 angeordnet sein. Die Abstandshalter 18 bilden für jede Schaltfläche 5 eine Art lichtdichten Hohlraum in dem sich die Beleuchtungsmittel 8 befinden. Somit ist sichergestellt, dass bei der Betätigung der jeweiligen Beleuchtungsmittel 8 nur die zugeordnete Schaltfläche 8 für den Anwender wahrnehmbar ist und die Lichtwellen 10 ausschließlich in Richtung der Abdeckplatte 4 aus diesem Hohlraum austreten können.

Um einen metallischen visuellen optischen Effekt zu erzeugen, ist im Strahlengang der Lichtwellen 9 der Beleuchtungsmittel 8 ein dünnwandiger Reflexionsschirm 11 angeordnet. Der Reflexionsschirm 11 kann dabei in der Abdeckplatte 4 integriert sein, auf der deren dem Inneren des Gehäuses 3 zugewandten Unterseite oder frei schwebend zwischen der Abdeckplatte 4 und dem Beleuchtungsmitteln 8 angeordnet sein. Der Reflexionsschirm 11 besteht aus einer äußerst dünnwandigen metallischen Struktur, die einen hohen Flächenwiderstand von mehr als 10 ³ Ohm/Square aufweist. Somit beeinflusst der Reflexionsschirm 11 die Kapazitäten der Sensorfläche 6 lediglich unwesentlich, so dass die technische Funktionsweise der Sensorfläche 6 weiter besteht.

Zudem weist der Reflexionsschirm 11 die optische Eigenschaft auf, dass die von den Beleuchtungsmitteln 8 ausgestrahlten Lichtwellen 9 durch diesen an definierten Stellen hindurchtreten können und an z.B. mit einer lichtundurchlässigen Absorptionsschicht 12 nach Art eines Sperrdrucks, versehenen Stellen, blockiert werden. Die von außen auf den Reflexionsschirm 11 auftreffenden Lichtwellen werden von dem Reflexionsschirm 11 teilweise reflektiert, gebrochen und/oder gestreut. Somit entsteht durch die Reflexion Streuung und/oder Brechung der äußeren Lichtwellen der optische Eindruck, dass die verwendeten Reflexionsschirme eine metallische glänzende Ästhetik aufweisen. Im ausgeschalteten Zustand erscheint die Oberfläche als durchgehend homogene metallene Fläche.

Darüber hinaus kann die Schaltvorrichtung 1 als eine Art Display 15 verwendet werden, wenn nämlich auf der Ober- und/oder Unterseite des Reflexionsschirmes lichtundurchlässige Absorptionsschichten 12 aufgetragen, aufgedruckt oder aufgeklebt sind. Die lichtundurchlässigen Absorptionsschichten 12 können Aussparungen 13 aufweisen, die lichtdurchlässig sind, so dass die Konturen der lichtundurchlässigen Absorptionsschichten 12 zu einem Schaltsymbol in Form von Zahlen, Buchstaben oder dergleichen ausgestaltet sind. Es ist ohne weiteres möglich die lichtundurchlässigen Absorptionsschichten 12 über die gesamte Oberfläche oder Unterseite der Reflexionsschirme 11 aufzutragen und die Aussparungen 12 mit den Lichtwellen der Beleuchtungsmittel 8 auszuleuchten.

Ebenso kann an der Stelle der Beleuchtungsmittel 8 ein oder mehrere herkömmliche Flachbildschirme oder Anzeigegeräte z.B. ein TFT- oder LC- Display 15 hinter den Reflexionsschirm 11 platziert werden, die in dem Betrieb durchscheinen, ausgeschalten jedoch nicht sichtbar sind und die Oberfläche homogen metallen erscheint. Die Lichtwellen 10 der Beleuchtungsmittel 8 können ebenfalls mittels Lichtleitern oder anderen optischen Bauteilen zu der jeweiligen Schaltflächen 5 gelenkt werden.

## Patentansprüche

1. Kapazitive Schaltvorrichtung (1) zur Erzeugung mindestens eines elektrisch auswertbaren Schaltsignals, durch das ein elektrisches Gerät, beispielsweise ein Telefon, eine Werkzeugmaschine, ein Kühlschrank oder dergleichen manuell bedienbar ist,
- mit einer in einem Gehäuse (3) angeordneten Abdeckplatte (4), die aus einem transparenten oder semitransparenten Werkstoff, insbesondere aus Glas oder aus einem Kunststoff, hergestellt ist, und durch die mindestens eine Schaltfläche (5) erkennbar und von außen bedienbar ist,
- mit mindestens einer ein Kapazitätsfeld erzeugende Sensorfläche (6), die aus einem elektrisch leitfähigen Werkstoff hergestellt und die auf eine im Inneren des Gehäuses (3) an vorgesehenen Träger- oder Leiterplatten (7) aufgebracht ist und die fluchtend zu der jeweiligen Schaltfläche (5) ausgerichtet ist,
- mit mindestens einem in dem Gehäuse (3) angebrachten Beleuchtungsmittel (8), insbesondere einer LED, durch die Lichtwellen (10), die in einem auf die Abdeckplatte (4) gerichteten Strahlengang (9) verlaufen, erzeugt sind und durch die die jeweilige Schaltfläche (5) beleuchtet ist und
- mit einer Spannungsquelle (14) zur Bestromung der Sensorfläche und den Beleuchtungsmitteln,
wobei ein Reflexionsschirm (11) frei schwebend zwischen der Abdeckplatte (4) und dem Beleuchtungsmittel (8) angeordnet ist, wobei der dünnwandige Reflexionsschirm (11) im Strahlengang (9) der jeweiligen Lichtwelle (10) der Beleuchtungsmittel (8) angeordnet ist, wobei die von den Beleuchtungsmitteln (8) in Richtung des Reflexionsschirmes (11) abgestrahlten Lichtwellen (10) durch diesen nach außen hindurchlaufen und wobei die von außen auf den Reflexionsschirm (11) einfallenden Lichtwellen von diesen teilweise reflektiert, gebrochen und/oder gestreut sind.

2. Schaltvorrichtung nach Anspruch 1,
**dadurch gekennzeichnet,**
**dass** auf der Ober- und/oder Unterseite des Reflexionsschirmes (11) eine lichtundurchlässige Absorptionsschicht (12) aufgebracht ist, dass die lichtundurchlässige Absorptionsschicht (12) ein oder mehrerer lichtdurchlässige Aussparungen (13) aufweist, dass die Aussparungen (13) ein Steuersymbol, beispielsweise in Form von Zahlen, Buchstaben oder dergleichen bilden oder vice versa.

3. Schaltvorrichtung nach Anspruch 1 oder 2,
**dadurch gekennzeichnet,**
**dass** der Reflexionsschirm (11) als Flächengebilde mit einer planen, gekrümmten oder gewellten Außenkontur ausgestaltet ist, die senkrecht zu dem Strahlengang (9) der Lichtwellen (10) verläuft, und dass durch die Wandstärke des Reflexionsschirmes (11) das von der Sensorfläche (6) abgestrahlte Kapazitätsfeld ungehindert oder nahezu ohne Abschirmeffekte durch diesen gelangt.

4. Schaltvorrichtung nach einem der vorgenannten Ansprüche,
**dadurch gekennzeichnet,**
**dass** sich die flächige Abmessung des Reflexionsschirmes (11) an die Abdeckplatte (4) angepasst ist und sich durchgängig über deren gesamte Fläche erstreckt.

5. Schaltvorrichtung nach einem der vorgenannten Ansprüche,
**dadurch gekennzeichnet,**
**dass** der Reflexionsschirm (11) beabstandet zu der Abdeckplatte (4) verläuft und durch das Gehäuse (3) lageorientiert gehalten ist.

6. Schaltvorrichtung nach einem der vorgenannten Ansprüche,
dass der Reflexionsschirm (11) aus einem elektrisch leitenden Werkstoff, vorzugsweise aus Metall hergestellt ist.

7. Schaltvorrichtung nach einem der vorgenannten Ansprüche,
**dadurch gekennzeichnet,**
**dass** der Werkstoff des Reflexionsschirmes (11) einen Flächenwiderstand größer als 10³ Ohm/square aufweist.

8. Schaltvorrichtung nach einem der vorgenannten Ansprüche,
**dadurch gekennzeichnet,**
**dass** zwischen den Beleuchtungsmittel (8) zweier benachbarter Schaltflächen (5) ein Abstandshalter (18) angeordnet ist, und dass der Abstandshalter (18) die benachbarten Schaltflächen (5) lichtdicht trennt.

9. Schaltvorrichtung nach einem der vorgenannten Ansprüche
**dadurch gekennzeichnet,**
**dass** die jeweilige Sensorfläche (6) lichtundurchlässig oder lichtreflektierend ausgestaltet ist und dass diese mit einem IC-Schaltkreis der Steuer- und Auswerteeinrichtung (16) elektrisch gekoppelt ist, durch die die Veränderungen des von der jeweiligen Sensorfläche (6) erzeugten Kapazitätsfeldes (2) im Bereich der Schaltfläche (5) in X- und/oder Y-Richtung bezogen auf das X-Y-Koordinatensystem (17) der Schaltfläche (5) erfassbar sind.

10. Schaltvorrichtung nach Anspruch 9,
**dadurch gekennzeichnet,**
**dass** durch eine elektrische Steuer- und Auswertevorrichtung (16), vorzugsweise einen Mikrocontroller, Mikroprozessor oder einen integrierten Schaltkreis, die jeweiligen Beleuchtungsmittel (8) elektrisch verbunden sind und dass in Abhängigkeit von der gemessenen bzw. erfassten Kapazitätsfeldveränderungen (2) auf der Schaltfläche (5) der Abdeckplatte (4) die Beleuchtungsmittel (8) durch die elektrische Steuereinrichtung (16) derart geschaltet sind, dass die Farbe der Lichtwellen (10) veränderbar ist oder dass die Beleuchtungsmittel (8) aus- bzw. eingeschaltet sind.

11. Schaltvorrichtung nach einem der vorgenannten Ansprüche,
**dadurch gekennzeichnet,**
**dass** in dem Strahlengang (9) der Lichtwellen (10) und räumlich vor dem Reflexionsschirm (11) ein TFT-Display (15) angeordnet ist

## Claims

1. A capacitative switch circuit (1) for generating at least one switching signal that can be evaluated electrically, by means of which an electrical device, for example a telephone, a machine tool, a refrigerator or the like, can be operated manually,
- with a cover plate (4) which is arranged in a housing (3), is manufactured from a transparent or semi-transparent material, in particular of glass or of a polymer, and through which at least one button (5) can be seen and operated from the outside,
- with at least one sensor surface (6) which generates a capacitance field, is manufactured from an electrically conductive material and is applied to a carrier or printed circuit board (7) provided in the interior of the housing (3) and is aligned flush with the respective button (5),
- with at least one illumination means (8), in particular an LED, mounted in the housing (3), by means of which light waves (10) are generated which run in a beam path (9) directed onto the cover plate (4) and by which the respective button (5) is illuminated, and
- with a voltage source (14) for energizing the sensor surface and the illumination means,
in which case a reflection screen (11) is arranged freely floating between the cover plate (4) and the illumination means (8), with the thin-walled reflection screen (11) being arranged in the beam path (9) of the respective light wave (10) of the illumination means (8), the light waves (10) emitted by the illumination means (8) in the direction of the reflection screen (11) passing through the latter to the outside and the light waves incident on the reflection screen (11) from the outside being partially reflected, refracted and/or scattered by the latter.

2. The switch circuit in accordance with Claim 1,
**characterised in that,**
an opaque absorption layer (12) is applied to the upper and/or lower side of the reflection screen (11), **in that** the opaque absorption layer (12) has one or more transparent recesses (13), **in that** the recesses (13) form a control symbol, for example in the form of numbers, letters or the like, or vice versa.

3. The switch circuit in accordance with Claim 1 or 2,
**characterised in that,**
the reflection screen (11) is designed as a planar structure with a flat, curved or corrugated outer contour which runs perpendicular to the beam path (9) of the light waves (10), and **in that**, due to the wall thickness of the reflection screen (11), the capacitance field emitted by the sensor surface (6) passes through the latter unhindered or virtually without any shielding effect.

4. The switch circuit in accordance with one of the aforementioned claims,
**characterised in that,**
the planar dimension of the reflection screen (11) is adapted to the cover plate (4) and extends continuously over its entire surface.

5. The switch circuit in accordance with one of the aforementioned claims,
**characterised in that,**
the refection screen (11) runs at a distance from the cover plate (4) and is held in position by the housing (3).

6. The switch circuit in accordance with one of the aforementioned claims,
**characterised in that,**
the reflection screen (11) is made of an electrically conductive material, preferably metal.

7. The switch circuit in accordance with one of the aforementioned claims,
**characterised in that,**
the material of the reflection screen (11) has a sheet resistance greater than 10³ ohm/square.

8. The switch circuit in accordance with one of the aforementioned claims,
**characterised in that,**
a spacer (18) is arranged between the illumination means (8) of two adjacent buttons (5), and **in that** the spacer (18) separates the adjacent buttons (5) in a light-tight manner.

9. The switch circuit in accordance with one of the aforementioned claims,
**characterised in that,**
the respective sensor surface (6) is opaque or light-reflecting, and **in that** it is electrically coupled to an integrated circuit of the control and evaluation device (16), by means of which the changes in the capacitance field (2) generated by the respective sensor surface (6) in the region of the button (5) in the X and/or Y direction relative to the X-Y coordinate system (17) of the button (5) can be detected.

10. The switch circuit in accordance with Claim 9,
**characterised in that,**
by means of an electrical control and evaluation device (16), preferably a microcontroller, microprocessor or integrated circuit, the respective illumination means (8) are electrically connected, and **in that**, as a function of the measured or detected capacitance field changes (2) on the switching surface (5) of the cover plate (4), the illumination means (8) are switched by the electrical control device (16) in such a way that the colour of the light waves (10) can be changed or that the illumination means (8) are switched off or on.

11. The switch circuit in accordance with one of the aforementioned claims,
**characterised in that,**
a TFT display (15) is arranged in the beam path (9) of the light waves (10) and spatially in front of the reflection screen (11).

## Revendications

1. Dispositif de commutation capacitif (1) servant à la génération d'au moins un champ électrique utilisable (2) permettant de commander manuellement p. ex. un téléphone, une machine-outil, un réfrigérateur ou un équipement similaire,
- avec une plaque de recouvrement (4) disposée dans un boîtier (3) et réalisée en matériau transparent ou semi-transparent, en particulier en verre ou en matière synthétique, et qui permet de reconnaître et de manipuler de l'extérieur au moins une face de commutation (5),
- avec au moins une face de capteur (6) générant un champ capacitif, réalisée en matériau conducteur d'électricité et qui est prévue à l'intérieur du boîtier (3) sur une platine-support ou un circuit-imprimé (7) et qui est en alignement précis sur la face de commutation respective (5),
- avec au moins un moyen d'éclairage (8), notamment une DEL, prévue dans le boîtier (3) et qui produit des ondes lumineuses (10) orientées sur un trajet de faisceau (9) orienté vers la plaque de recouvrement (4), et qui éclaire la face de commutation respective (5),
- et avec une source de courant (14) alimentant la face de commutation et les moyens d'éclairage
où il est prévu un écran de réflexion (11) flottant librement entre la plaque de recouvrement (4) et le moyen d'éclairage (8),
où l'écran de réflexion à paroi mince (11) se trouve dans le trajet de faisceau (9) de l'onde lumineuse respective (10),
où les ondes lumineuses (10) émises par les moyens d'éclairage (8) en direction de l'écran de réflexion (11) traversent celui-ci vers l'extérieur et
où les ondes lumineuses atteignant l'écran de réflexion (11) de l'extérieur sont réfléchies, réfractées et/ou dispersées partiellement par celui-ci.

2. Dispositif de commutation d'après la revendication 1,
**caractérisé en ce que**
sur la face supérieure et/ou sur la face inférieure de l'écran de réflexion (11), il est appliqué une couche d'absorption opaque (12), que cette couche d'absorption opaque (12) possède un ou plusieurs évidements translucides (13) et que les évidements (13) forment un symbole de commande, p.ex. sous la forme de chiffres, de lettres et inversement.

3. Dispositif de commutation d'après la revendication 1 ou 2,
**caractérisé en ce que**
l'écran de réflexion (11) est conçu sous la forme d'une surface possédant un contours extérieur plan, courbé ou ondulé s'étendant perpendiculairement au trajet de faisceau (9) des ondes lumineuses (10), et que l'épaisseur de la paroi de l'écran de réflexion (11) permet au champ capacitif émis par la face de capteur (6) de traverser celui-ci sans encombre ou presque sans effets de blindage.

4. Dispositif de commutation d'après une des revendications précédentes,
**caractérisé en ce que**
les dimensions de la surface de l'écran de réflexion (11) sont adaptées à la plaque de recouvrement (4) et qu'elle s'étendent sur la totalité de sa surface.

5. Dispositif de commutation d'après une des revendications précédentes,
**caractérisé en ce que**
l'écran de réflexion (11) est espacé de la plaque de recouvrement (4) et qu'il est retenu en position définie par le boîtier (3).

6. Dispositif de commutation d'après une des revendications précédentes,
**caractérisé en ce que**
l'écran de réflexion (11) est réalisé en matériau conducteur d'électricité, de préférence en métal.

7. Dispositif de commutation d'après une des revendications précédentes,
**caractérisé en ce que**
le matériau de l'écran de réflexion (11) possède une résistivité superficielle supérieure à 10³ Ohm/square.

8. Dispositif de commutation d'après une des revendications précédentes,
**caractérisé en ce que**,
entre les moyens d'éclairage (8) de deux faces de commutation voisines (5), il est prévu en écarteur (18) et que l'écarteur (18) sépare les faces de commutation voisines (5) de manière étanche à la lumière.

9. Dispositif de commutation d'après une des revendications précédentes,
**caractérisé en ce que**
la face de capteur respective (6) est conçue de manière opaque ou réfléchissant la lumière et que celle-ci est accouplée électriquement à un circuit intégré de l'équipement de commande et d'évaluation (16), de sorte à pouvoir saisir les changements du champ capacitif (2) généré par la face de capteur respective (6) au niveau de la face de commutation (5), en directions X et/ou Y avec référence au système de coordonnées X-Y (17) de la face de commutation (5).

10. Dispositif de commutation d'après la revendication 9,
**caractérisé en ce que**
grâce à un équipement de commande et d'évaluation (16), de préférence un microcontrôleur, un microprocesseur ou un circuit intégré, les moyens d'éclairage respectifs (8) sont raccordés électriquement et que, en fonction des changements du champ capacitif (2) mesurés ou saisis sur la face de commutation (5) de la plaque de recouvrement (4), les moyens d'éclairage (8) sont actionnés par l'équipement de commande électrique (16) de sorte que la couleur des ondes lumineuses (10) soit variable ou que les moyens d'éclairage (8) soient activés ou désactivés.

11. Dispositif de commutation d'après une des revendications précédentes,
**caractérisé en ce que**
dans le trajet de faisceau (9) des ondes lumineuses (10) et devant l'écran de réflexion (11), il est prévu un affichage TFT (15).
